# EUROPEAN PATENT APPLICATION

(11) **EP 4 779 437 A1**
(43) Date of publication of application: **22.07.2026**
(21) Application number: 26152436.7
(22) Date of filing: 16.01.2026
(51) Int. Cl.: G06F 1/185, G06F 1/20, H01R 13/00, H05K 1/02, H01R 12/72

(54) **LIQUID-COOLED SLOT FOR EXPANSION CARD**

(30) Priority: 17.01.2025 US 202519029728
(71) Applicant: Aivres Systems Inc., Fremont California 94538 (US)
(72) Inventor: Nien, Chia-Yuan, TaiChung (TW)
(74) Representative: Marks & Clerk LLP

(57) **Abstract**

Disclosed herein is a liquid-cooled connector device for connecting with a computer expansion board. The device comprises a circuit board slot comprising a plurality of electrical contacts, a fluid supply conduit abutting a first side of the circuit board slot, a fluid return conduit abutting a second side of the circuit board slot opposite to the first side, a fluid supply connector fluidically connected to the fluid supply conduit, and a fluid return connector fluidically connected to the fluid return conduit. The fluid supply conduit and the fluid return conduit are in thermal contact with the circuit board slot.

## Description

### TECHNICAL FIELD

This disclosure is generally related to a liquid-cooled expansion slot for use in computer systems.

### BACKGROUND

In computer systems, including workstations and servers, electrical components and associated circuitry are often provided on a motherboard, which is a circuit board generally comprising a flat sheet-like material having a height and a width dimension, the material having a nominal thickness. Various electrical components are mounted to one or both sides of the motherboard. The internal electrical connections between the electrical components located on the motherboard are often formed using electrically conductive traces printed onto or otherwise provided on the material forming the motherboard. In addition, the motherboard frequently includes a device that includes a plurality of expansion slots configured to allow the insertion and removal of various types of expansion cards, such as a graphical processing unit (GPU) card or a coprocessor card, into and from, respectively, each of the expansion slots. Once an expansion card is installed in one of the plurality of module slots, electrical contacts associated with the expansion slot are electrically coupled to electrical contacts provided as part of the expansion card in order to provide electrical connections between the components on the expansion card and the components included on the motherboard.

Electrical contacts for electrical coupling of expansion cards with the expansion slots on the motherboard are often provided as conductive contacts formed along one edge of the circuit board of the expansion card. The expansion cards are usually configured such that the expansion card may be releasably inserted into the slot that also includes electrical contacts or connectors or terminals.

Each expansion slot is configured to accept an expansion card having the proper dimensions and conforming to any other physical and electrical parameters designated for expansion cards to be accepted by the slot. An expansion card having the proper form factor can be inserted into the expansion slot, and, when fully inserted, engage the electrical contacts provided in that particular slot, thus forming the electrical connections between the card and the slot. In some examples, the card includes a mechanism to secure the card in place once the card has been fully inserted into a slot. Once inserted into a slot, the card can also be removed from a slot in order to service the card, thus allowing for replacement of a defective card, or simply to change the type of card provided by the system associated with the card cage.

One of the biggest problems that determine the limitation in performance of computers in recent years is heat dissipation. For example, it is sometimes estimated that 45% or so of the power consumption by the whole data centers are consumed for cooling. Therefore, there is a strong demand for improvements in cooling efficiency.

Heretofore, both air-cooling type and liquid-cooling type have been used for cooling computers. Liquid-cooling is generally recognized to be the more efficient type of cooling mechanism because liquids have higher densities and therefore superior heat transfer properties in comparison with air. Liquid-cooling works by bring a cold liquid in thermal contact with heat producing components (such as CPU and GPU), which takes away the heat due to the temperature difference between the heat producing components and the cooling liquid.

GPUs, because of their high thermal power, can benefit tremendously from liquid cooling. But in that case, when installing a liquid-cooled GPU card in a computer system, it is insufficient to merely insert the GPU card into an empty slot on the motherboard. Tubes for supplying and returning the cooling liquid must also be connected. Not only does this introduce an extra manual step, but the tubes also frequently get in the way of other components in the computer chassis, which has limited space.

The liquid-cooled expansion slot disclosed herein includes both electrical contacts and quick coupling connectors, such that a liquid-cooled GPU card can be easily installed by inserting it into the expansion slot, where electrical connections and liquid connections are established at the same time. Furthermore, expansion slot disclosed herein also employs liquid-cooling to lower the temperature of the electrical contacts at the edge of the GPU card (i.e., the "gold fingers").

### SUMMARY

Described herein is a liquid-cooled expansion slot for use in computer systems.

In one general aspect, disclosed herein is a circuit board slot comprising a plurality of electrical contacts, a fluid supply conduit abutting a first side of the circuit board slot, a fluid return conduit abutting a second side of the circuit board slot opposite to the first side, a fluid supply connector fluidically connected to the fluid supply conduit, and a fluid return connector fluidically connected to the fluid return conduit. In some embodiments, each of the fluid supply conduit and the fluid return conduit is in thermal contact with the circuit board slot.

In some embodiments, the circuit board slot is adapted to hold an edge of a circuit board and electrically couple with the circuit board via the plurality of electrical contacts. In some embodiments, the circuit board is a GPU card having a PCI Express electrical interface and form factor. In some embodiments, the fluid supply conduit and the fluid return conduit are adapted to transfer heat from the edge of the circuit board and the plurality of electrical contacts to a cooling liquid. In some embodiments, the fluid supply connector is adapted to couple with a fluid inlet on the circuit board, and the fluid return connector is adapted to couple with a fluid outlet on the circuit board.

In some embodiments, the circuit board slot is adapted to receive a PCI Express card, a PCI-X card, a PCI card, an AGP card, or a VESA card. In some embodiments, the circuit board slot is adapted to receive a multi-lane PCI Express card of x16, x8, or x4 link width. In some embodiments, the multi-lane PCI Express card is a GPU card or a coprocessor card.

In some embodiments, the plurality of electrical contacts in the circuit board slot are gold plated.

In some embodiments, each of the fluid supply connector and the fluid supply connector is a female connector. In some embodiments, each of the fluid supply connector and the fluid supply connector is a quick coupling connector.

In some embodiments, each of the fluid supply connector and the fluid return connector is arranged substantially on a longitudinal axis of the circuit board slot. In some embodiments, the fluid supply connector and the fluid return connector are disposed on one end of the longitudinal axis, and the circuit board slot is disposed on the other end of the longitudinal axis. In some embodiments, the fluid supply connector and the fluid return connector are disposed on opposite ends of the longitudinal axis, and the circuit board slot is disposed in between the connectors.

In another general aspect, disclosed herein is a device comprising a circuit board slot comprising a plurality of electrical contacts, a fluid supply conduit abutting a first side of the circuit board slot, a fluid return conduit abutting a second side of the circuit board slot opposite to the first side, a fluid supply connector fluidically connected to the fluid supply conduit, and a fluid return connector fluidically connected to the fluid return conduit. In some embodiments, the circuit board slot is adapted to hold an edge of a circuit board and electrically couple with the circuit board via the plurality of electrical contacts. In some embodiments, the fluid supply connector is adapted to couple with a fluid inlet on the circuit board, and the fluid return connector is adapted to couple with a fluid outlet on the circuit board. In some embodiments, the fluid supply conduit and the fluid return conduit are adapted to transfer heat from the edge of the circuit board and the plurality of electrical contacts to a cooling liquid. In some embodiments, the circuit board is a computer expansion board having a PCI Express electrical interface and form factor.

In yet another general aspect, disclosed herein is a computer system comprising a motherboard comprising a connector device, and a liquid-cooled GPU card comprising a liquid inlet and a liquid outlet. In some embodiments, the connector device comprises a circuit board slot comprising a plurality of electrical contacts, a fluid supply conduit abutting a first side of the circuit board slot, a fluid return conduit abutting a second side of the circuit board slot opposite to the first side, a fluid supply connector fluidically connected to the fluid supply conduit, and a fluid return connector fluidically connected to the fluid return conduit. In some embodiments, the circuit board slot holds an edge of the liquid-cooled GPU card and electrically couples with the liquid-cooled GPU card via the plurality of electrical contacts. In some embodiments, the fluid supply connector couples with the liquid inlet of the liquid-cooled GPU card, and the fluid return connector couples with the liquid outlet of the liquid-cooled GPU card. In some embodiments, the fluid supply conduit and the fluid return conduit are adapted to transfer heat from the edge of the liquid-cooled GPU card and the plurality of electrical contacts to a cooling liquid.

In some embodiments, the fluid supply connector and the fluid return connector are female connectors, and the liquid inlet and the liquid outlet of the liquid-cooled GPU card are male connectors.

In some embodiments, the liquid-cooled GPU card has a PCI Express electrical interface and form factor.

In some embodiments, each of the fluid supply connector and the fluid return connector is arranged substantially on a longitudinal axis of the circuit board slot.

In some embodiments, the computer system further comprises a pump. In some embodiments, the pump is adapted to circulate the cooling liquid through the fluid supply conduit, the liquid-cooled GPU card, and the fluid return conduit.

### BRIEF DESCRIPTION OF THE DRAWINGS

Certain features of various embodiments of the present technology are set forth with particularity in the appended claims. A better understanding of the features and advantages of the technology will be obtained by reference to the following detailed description that sets forth illustrative embodiments, in which the principles of the disclosure are utilized, and the accompanying drawings of which:
FIG. 1 illustrates the components of a liquid-cooled slot according to the present disclosure.
FIGS. 2 and 3 show respectively a lateral view and an isomeric view of a liquid-cooled expansion card inserted into a liquid-cooled slot of the present disclosure.

### DETAILED DESCRIPTION OF EMBODIMENTS

In the following description, certain specific details are set forth in order to provide a thorough understanding of various embodiments of the disclosure. However, one skilled in the art will understand that the disclosure may be practiced without these details. Moreover, while various embodiments of the disclosure are disclosed herein, many adaptations and modifications may be made within the scope of the disclosure in accordance with the common general knowledge of those skilled in this art. Such modifications include the substitution of known equivalents for any aspect of the disclosure in order to achieve the same result in substantially the same way.

Unless the context requires otherwise, throughout the present specification and claims, the word "comprise" and variations thereof, such as, "comprises" and "comprising" are to be construed in an open, inclusive sense, that is as "including, but not limited to." Recitation of numeric ranges of values throughout the specification is intended to serve as a shorthand notation of referring individually to each separate value falling within the range inclusive of the values defining the range, and each separate value is incorporated in the specification as it were individually recited herein. Additionally, the singular forms "a," "an" and "the" include plural referents unless the context clearly dictates otherwise.

Reference throughout this specification to "one embodiment" or "an embodiment" means that a particular feature, structure, or characteristic described in connection with the embodiment is included in at least one embodiment of the present disclosure. Thus, the appearances of the phrases "in one embodiment" or "in an embodiment" in various places throughout this specification are not necessarily all referring to the same embodiment, but may be in some instances. Furthermore, the particular features, structures, or characteristics may be combined in any suitable manner in one or more embodiments.

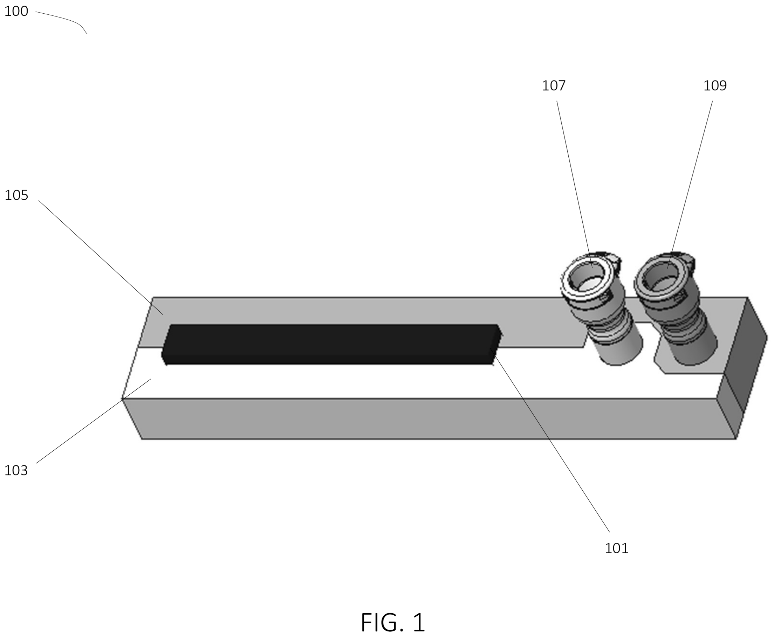

The embodiments will now be explained with the accompanying figures. Reference is first made to FIG. 1, which shows a device 100 that is a liquid-cooled expansion slot. In FIG. 1, the device 100 includes a circuit board slot 101, a fluid supply conduit 103 abutting one side of the circuit board slot 101, a fluid return conduit 105 abutting the opposite side of the circuit board slot 101, a fluid supply connector 107 fluidically connected to the fluid supply conduit 103; and a fluid return connector 109 fluidically connected to the fluid return conduit 105. The fluid supply conduit 103 and the fluid return conduit 105 are in thermal contact with the circuit board slot 101.

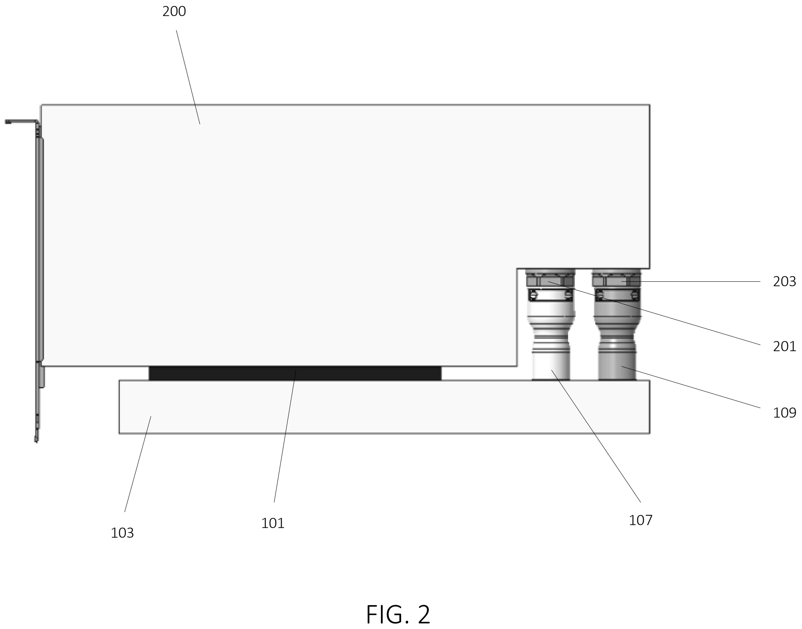

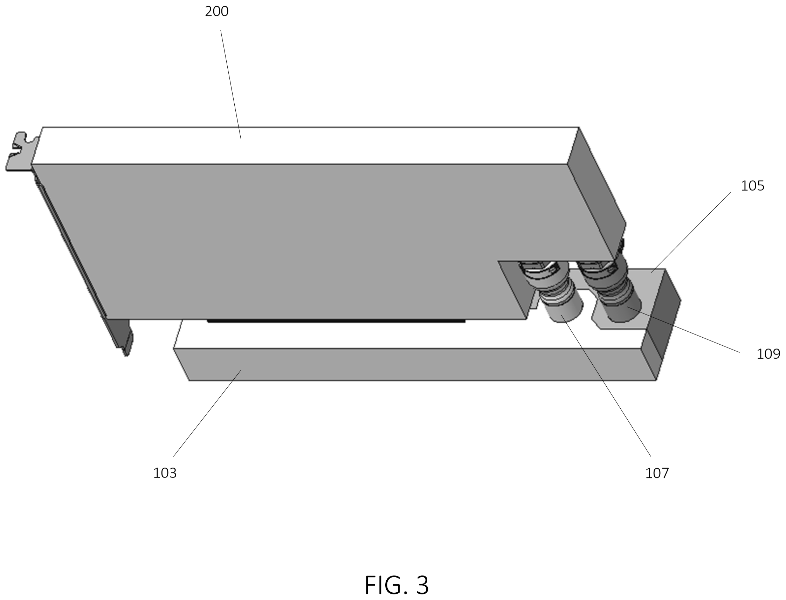

FIGS. 2 and 3 show a liquid-cooled expansion card 200, which may be a liquid-cooled GPU card, installed in the device 100 shown in FIG. 1. In FIGS. 2 and 3, an edge of the liquid-cooled expansion card 200 is inserted into the circuit board slot 101. The circuit board slot 101 holds an edge of the expansion card 200 and electrically couples with the expansion card 200. Connections for cooling liquid are also established with the expansion card 200. The expansion card 200 includes inlet 201 and outlet 203 for receiving and returning cooling liquid. The inlet 201 is connected with the fluid supply connector 107, and the outlet 203 is connected with the fluid return connector 109.

In some embodiments, the fluid supply and return connectors can be quick coupling connectors. Quick coupling connectors (also referred to as quick connect fittings) are connectors that join fluid lines. They are designed to be used without tools and connect with a simple push or twist. There are a variety of quick coupling connectors that may be used. "Ball and sleeve" type quick coupling connectors feature a retractable sleeve that connects coupler halves. The male ball end fits into the female outer sleeve. For example, FloLok^{®} Quick Connect is a type of ball and sleeve fitting. "Push to connect" is another type of quick coupling connectors that works similarly to ball and sleeve connections. Push to connect connectors function by pushing one end into the other. To disconnect, a collar is retracted. "Cam-lock" is a type of quick coupling connectors that use foldable tabs on the female half to lock the receiver in place. "Luer lock" is another type of quick coupling connectors that connects by twisting and is commonly used in syringes and needles. There are also twist or bayonet connectors that utilize a 1/8 to 1/4 turn to connect and disconnect.

In some embodiments, the fluid supply and return connectors can be Stäubli^{™}-branded non-spill quick-release couplings, including CGB, CGD, CGO, and DDG connectors.

In addition to establishing liquid connections with the expansion card inserted into the slot, the fluid supply and return connectors also help secure the expansion card in place, which is an additional feature of the present design, since modern GPU cards are becoming increasingly heavier and bulkier.

Each of the fluid supply conduit and the fluid return conduit includes one or more internal channels that permit the flow of cooling liquid. The fluid supply conduit and the fluid return conduit can each made as a continuous body of material that has a high propensity for conducting heat although they may also be formed in multiple attached pieces. Suitable materials include aluminum, copper, and/or other metal alloys, plastic and/or epoxy, and/or any other suitable heat conducting material. In one embodiment, each of the fluid supply conduit and the fluid return conduit is formed from a continuous piece of aluminum alloy and its side is shaped to fit the contour of the circuit board slot to maximize thermal transfer.

The expansion slot disclosed herein provides both electrical connections and cooling liquid connections to an expansion card at the same time. Furthermore, the fluid supply conduit and the fluid return conduit also cool the electrical contacts (i.e., the "gold fingers") at the edge of the expansion card. The expansion slot disclosed herein facilitates cooling of a GPU card inserted into the slot, or any other expansion card with high thermal dissipation power.

The foregoing description of the present disclosure has been provided for the purposes of illustration and description. It is not intended to be exhaustive or to limit the disclosure to the precise forms disclosed. The breadth and scope of the present disclosure should not be limited by any of the above-described exemplary embodiments. Many modifications and variations will be apparent to the practitioner skilled in the art. The modifications and variations include any relevant combination of the disclosed features. The embodiments were chosen and described in order to best explain the principles of the disclosure and its practical application, thereby enabling others skilled in the art to understand the disclosure for various embodiments and with various modifications that are suited to the particular use contemplated. It is intended that the scope of the disclosure be defined by the following claims and their equivalence.

## Claims

1. A device comprising:
a circuit board slot comprising a plurality of electrical contacts;
a fluid supply conduit abutting a first side of the circuit board slot;
a fluid return conduit abutting a second side of the circuit board slot opposite to the first side;
a fluid supply connector fluidically connected to the fluid supply conduit; and
a fluid return connector fluidically connected to the fluid return conduit; and
wherein each of the fluid supply conduit and the fluid return conduit is in thermal contact with the circuit board slot.

2. The device of claim 1, wherein the circuit board slot is adapted to hold an edge of a circuit board and electrically couple with the circuit board via the plurality of electrical contacts.

3. The device of claim 2, wherein the circuit board is a GPU card having a PCI Express electrical interface and form factor.

4. The device of claim 2, wherein the fluid supply conduit and the fluid return conduit are adapted to transfer heat from the edge of the circuit board and the plurality of electrical contacts to a cooling liquid.

5. The device of claim 2, wherein the fluid supply connector is adapted to couple with a fluid inlet on the circuit board, and the fluid return connector is adapted to couple with a fluid outlet on the circuit board.

6. The device of claim 1, wherein the circuit board slot is adapted to receive a PCI Express card, a PCI-X card, a PCI card, an AGP card, or a VESA card.

7. The device of claim 1, wherein the circuit board slot is adapted to receive a multi-lane PCI Express card of x16, x8, or x4 link width, and, optionally, wherein the multi-lane PCI Express card is a GPU card or a coprocessor card.

8. The device of claim 1, wherein the plurality of electrical contacts in the circuit board slot are gold plated.

9. The device of claim 1, wherein each of the fluid supply connector and the fluid supply connector is a female connector or a quick coupling connector.

10. The device of claim 1, wherein each of the fluid supply connector and the fluid return connector is arranged substantially on a longitudinal axis of the circuit board slot, and, optionally, wherein the fluid supply connector and the fluid return connector are disposed on one end of the longitudinal axis, and the circuit board slot is disposed on the other end of the longitudinal axis.

11. A device comprising:
a circuit board slot comprising a plurality of electrical contacts;
a fluid supply conduit abutting a first side of the circuit board slot;
a fluid return conduit abutting a second side of the circuit board slot opposite to the first side;
a fluid supply connector fluidically connected to the fluid supply conduit; and
a fluid return connector fluidically connected to the fluid return conduit; and
wherein the circuit board slot is adapted to hold an edge of a circuit board and electrically couple with the circuit board via the plurality of electrical contacts;
wherein the fluid supply connector is adapted to couple with a fluid inlet on the circuit board, and the fluid return connector is adapted to couple with a fluid outlet on the circuit board;
wherein the fluid supply conduit and the fluid return conduit are adapted to transfer heat from the edge of the circuit board and the plurality of electrical contacts to a cooling liquid; and
wherein the circuit board is a computer expansion board having a PCI Express electrical interface and form factor.

12. A computer system comprising:
a motherboard comprising a connector device; and
a liquid-cooled GPU card comprising a liquid inlet and a liquid outlet; and
wherein the connector device comprises:
a circuit board slot comprising a plurality of electrical contacts;
a fluid supply conduit abutting a first side of the circuit board slot;
a fluid return conduit abutting a second side of the circuit board slot opposite to the first side;
a fluid supply connector fluidically connected to the fluid supply conduit; and
a fluid return connector fluidically connected to the fluid return conduit;
wherein the circuit board slot holds an edge of the liquid-cooled GPU card and electrically couples with the liquid-cooled GPU card via the plurality of electrical contacts;
wherein the fluid supply connector couples with the liquid inlet of the liquid-cooled GPU card, and the fluid return connector couples with the liquid outlet of the liquid-cooled GPU card; and
wherein the fluid supply conduit and the fluid return conduit are adapted to transfer heat from the edge of the liquid-cooled GPU card and the plurality of electrical contacts to a cooling liquid.

13. The computer system of claim 12, wherein the fluid supply connector and the fluid return connector are female connectors; and wherein the liquid inlet and the liquid outlet of the liquid-cooled GPU card are male connectors, or, wherein the liquid-cooled GPU card has a PCI Express electrical interface and form factor.

14. The computer system of claim 12, wherein each of the fluid supply connector and the fluid return connector is arranged substantially on a longitudinal axis of the circuit board slot.

15. The computer system of claim 12, further comprising a pump, and, optionally, wherein the pump is adapted to circulate the cooling liquid through the fluid supply conduit, the liquid-cooled GPU card, and the fluid return conduit.
